# EUROPEAN PATENT APPLICATION

(11) **EP 4 657 202 A1**
(43) Date of publication of application: **03.12.2025**
(21) Application number: 24178772.0
(22) Date of filing: 29.05.2024
(51) Int. Cl.: G06F 1/20, H05K 7/20

(54) **METHOD AND MACHINE FOR CARRYING OUT MAINTENANCE ON A LIQUID COOLING SYSTEM**

(71) Applicant: EKWB d.o.o., 1218 Komenda (SI)
(72) Inventor: König, Edvard, 4270 Jesenice (SI)
(74) Representative: Schaumburg und Partner Patentanwälte mbB

(57) **Abstract**

In one aspect, a method is provided for carrying out maintenance on a liquid cooling system (104) for a computer (106). The method comprises a step of connecting a maintenance machine (102) to the liquid cooling system (104). Further, the method comprises a step of filling the liquid cooling system (104) with a cooling liquid by means of the maintenance machine (102). In further aspects, a maintenance machine for carrying out maintenance on a liquid cooling system (104) is provided and a bypass valve block (300, 400, 500, 700) for connecting a maintenance machine (102) to a liquid cooling system (104) is provided.

## Description

### Technical field

The present invention relates to a method for carrying out maintenance on a liquid cooling system for a computer. In further aspects a respective maintenance machine is provided as well as a bypass valve block for connecting the maintenance machine to the liquid cooling system.

### Background

Waste heat produced by a computer hardware component is required to be removed by a suitable computer cooling system in order to keep the computer component within permissible operating temperature limits. Whereas computer operating systems may be designed to reduce power consumption and resulting heating, high-performance computer hardware components including integrated circuits, coprocessors, peripheral electronic circuit cards, for example central processing units (CPUs), graphics processing units (GPUs), etc. require efficient cooling to prevent overheating. For this, active cooling systems are often used to remove excess heat from the hardware components and/or actively reduce the ambient temperature within the chassis of a computer, such as by exhausting hot air by means of computer fans. Further, a more sophisticated approach is liquid cooling which may be applied to actively remove excess heat from powerful individual computer hardware components as CPUs or GPUs.

Whilst liquid cooling system are generally robust and reliable for cooling applications of computer hardware, the handling of cooling liquid in maintenance operations may generally pose difficulties, even for experienced persons. In the extreme, the handling of cooling liquids and related systems may be dangerous, in particular for unexperienced lay persons. For example, the computer hardware may be damaged, if it accidentally comes into contact with cooling liquid, for example due to a spill. Additionally, computer hardware regularly has open electric connections that pose a risk for electric injury for a person carrying out maintenance on a liquid cooling system, in particular in case of a spill of cooling liquid.

### Summary

It is an objective of the present invention to provide methods and means that allow easy and safe maintenance of liquid cooling systems for computer systems.

The afore-mentioned objective is achieved by the subject-matter of the independent claims. Advantageous embodiments are defined in the dependent claims and the following description.

In one aspect, a method is provided for carrying out maintenance on a liquid cooling system for a computer. The method comprises a step of connecting a maintenance machine to the liquid cooling system. Further, the method comprises a step of filling the liquid cooling system with a cooling liquid by means of the maintenance machine.

The method enables easily and safely carrying out maintenance on a liquid cooling system, in particular, the use of the maintenance machine minimises manual intervention by a person carrying out the maintenance and reduces the risk for operating errors. Moreover, the reduction of errors reduces the frequency at which carrying out the method is necessary. Further, the method enables efficient maintenance of liquid cooling systems, in particular due to minimisation of manual intervention. Moreover, the method reduces labour required and it is therefore easy and efficient to regularly repeat the method and thereby increase performance and longevity of a cooling system.

Generally, the step of filling the liquid cooling system follows the step of connecting the maintenance machine. In particular, the maintenance machine is external to the liquid cooling system and therefore does not form part of the cooling system. The maintenance machine may be reversibly connected to the liquid cooling system. Further, the maintenance machine is generally only connected for carrying out maintenance on the liquid cooling system.

The step of filling the liquid cooling system with a cooling liquid may, in particular, filling a preset volume of cooling liquid, proportionate to a filling volume of the liquid cooling system, into the cooling system. Further, the step may include circulating the cooling liquid through the liquid cooling system.

In particular, the computer may comprise heat-generating electronic circuits that may be cooled by means of the liquid cooling system. Generally, the computer may be a personal computer or a server, for example.

Preferably, the maintenance machine is connected to a bypass valve block of the liquid cooling system, in particular in step a) of the method. This enables easily connecting the maintenance machine to the liquid cooling system. In particular, the maintenance machine may have a supply line and a return line for supplying or returning fluids between the maintenance machine and the liquid cooling system. The supply and return lines may be connected to a liquid cooling loop of the liquid cooling system by means of the bypass valve block such that the maintenance machine forms part of the liquid cooling loop when it is connected to the liquid cooling system. The step of connecting the maintenance machine to a bypass valve block may include actuating at least a first valve of the bypass valve block or remove plugs of the bypass valve block to fluidly connect the maintenance machine to the liquid cooling system.

Preferably, the liquid cooling system is drained or emptied, for example, by means of the maintenance machine. This enables efficient filling of fresh cooling liquid into the liquid cooling system in step b), for example. In particular, this may remove a previous cooling liquid from the cooling system and avoid mixing with or contamination of the fresh cooling liquid. In particular, this step may be carried out subsequent to step a) and prior to step b). The liquid cooling system may be drained by applying pressurised fluid, for example a gas such as nitrogen or air, to the liquid cooling loop. Alternatively, a vacuum may be used to drain the liquid cooling system.

Preferably, a leak test of the liquid cooling system is performed, for example, by means of the maintenance machine. In particular, this enables the subsequent safe filling of liquids into the liquid cooling system. Preferably, the leak test is performed subsequent to step a) and prior to step b). For example, the leak test may be performed by initially pressurising the liquid cooling system, in particular the liquid cooling loop, with a fluid, such as a gas or a pressurisation liquid, and observing, if subsequently the pressure in the liquid cooling loop drops. To that end, the pressure in the liquid cooling loop may be observed for a preset amount of time. The pressure used may be in a range between 0.5 to 3 bar, for example.

Preferably, the liquid cooling system is flushed with a cleaning liquid, for example by means of the maintenance machine. In particular, this step if carried out prior to step b). This enables cleaning of the liquid cooling loop, in particular removing any fouling or scaling from lines or heat exchangers. The cleaning liquid may comprise a detergent, for example. The cleaning liquid may be drained or removed from the liquid cooling system to waste after flushing the liquid cooling system. The liquid cooling system may be drained by applying pressurised fluid, for example a gas such as nitrogen or air, to the liquid cooling loop.

Preferably, the liquid cooling system is flushed with a rinsing liquid, for example, by means of the maintenance machine. In particular, the liquid cooling system is flushed with a rinsing liquid after flushing with a cleaning liquid and prior to filling with a cooling liquid. This enables removing traces of the cleaning liquid prior to filling with the cooling liquid. The rinsing liquid may be drained or removed from the liquid cooling system to waste after flushing the liquid cooling system, in particular prior to filling with the cooling liquid. The liquid cooling system may be drained by applying pressurised fluid, for example a gas such as nitrogen or air, to the liquid cooling loop.

Preferably, the cleaning liquid is configured to remove or dissolve fouling or scaling from lines or heat exchangers of the liquid cooling system. The cooling liquid is preferably configured to have at least one of a high thermal capacity, a low viscosity, chemical inertness, and non-corrosiveness. Preferably, at least the rinsing liquid is miscible in the cleaning liquid and the cooling liquid. This enables efficiently removing the cleaning liquid prior to introducing the cooling liquid to the liquid cooling system and avoiding a degradation of the desirable properties of the cooling liquid due to the presence of the cleaning liquid. Moreover, flushing with cleaning and rinsing liquids may reduce contaminants in the liquid cooling system and improve longevity of the cooling liquid and the components of the liquid cooling system.

In a preferred embodiment, liquids, such as cooling, cleaning or rinsing liquids, may be removed or drained from the liquid cooling system by using a pressurised gas or a vacuum. In a particularly preferred embodiment, a combination of both may be used. The use of a vacuum reduces the introduction of excess air or air bubbles into the liquid cooling system or cooling liquid. This increases the thermal performance of the liquid cooling system.

The method and its use of the maintenance machine reduces or avoids the need to disassemble the liquid cooling system for maintenance. In particular in view of the steps of flushing with a cleaning liquid and/or rinsing liquid, the method therefore enables increasing efficiency by carrying out the steps by means of the maintenance machine.

Preferably, a maintenance report is generated, for example, by means of the maintenance machine. For example, the maintenance report enables providing feedback to an operator or user. For example, the maintenance report may comprise a protocol of at least one maintenance step of the method that was carried out, in particular, if the step was carried out successfully. Further, the maintenance report may provide a protocol for regulatory compliance or for warranty purposes. Preferably, the maintenance report is generated after step b). The maintenance report may be printed, for example by means of a printer of the maintenance machine, or

Preferably, the maintenance machine is disconnected from the liquid cooling system, in particular from the bypass valve block, after step b). Preferably, this comprises actuating at least the first valve to fluidly disconnect the maintenance machine from the liquid cooling system, in particular from the liquid cooling loop. Thus, the maintenance machine no longer forms part of the liquid cooling loop of the cooling system after this step. This Preferably, this step is carried out after step b).

Preferably, the cooling liquid is circulated in the liquid cooling system. This enables removing remaining gas bubbles in the liquid cooling loop. In particular, this may be carried out after step b). The cooling liquid may be circulated by means of a circulation pump of the liquid cooling system or, if the maintenance machine is connected to the liquid cooling system, by means of the maintenance machine.

In particularly preferred embodiment, at least the following steps are performed: performing the leak test, flushing the liquid cooling system with the cleaning liquid, flushing the liquid cooling system with the rinsing liquid, filling the liquid cooling system with the cooling liquid, and generating a maintenance report comprising a protocol of the performed steps. In particular, the steps are performed in this order.

In a further aspect, a maintenance machine for carrying out maintenance on a liquid cooling system for a computer is provided. The maintenance machine comprises means to carry out the method for carrying out maintenance on a liquid cooling system for a computer, in particular as described above.

For example, the maintenance machine may comprise at least one of the following components: a fluid pump, in particular configured to pump or circulate liquid, such as the cleaning liquid, the rinsing liquid, and the cooling liquid, to the liquid cooling system; a compressor configured to provide pressurised gas, such as air, for flushing lines, in particular, the liquid cooling loop of the liquid cooling system, with the gas; liquid containers, in particular for the cleaning liquid, the rinsing liquid, the cooling liquid, and for waste liquids; fluid lines, in particular to fluidly connect the liquid containers and the pump to the liquid cooling system; the fluid lines may comprise connectors, in particular to reversibly connect to a bypass valve block of the liquid cooling system; valves and/or manifolds configured to selectively connect the fluid containers to the liquid cooling system, in particular via the pump; at least one pressure sensor configured to determine a pressure in the liquid cooling system, in particular the liquid cooling loop, or in the fluid lines of the maintenance machine; a display and/or a printer configured to provide the maintenance report; a control system configured to carry out the steps of the method, in particular configured to direct the components of the maintenance machine to carry out the method; the maintenance machine may also comprise input and output means, for example, to notify a user of currently performed steps or parameters, or to receive input from a user as to what steps to perform. The fluid pump may be a vacuum pump, or in addition the maintenance machine may comprise a vacuum pump. The vacuum pump may be preferred for filling or draining the steps of the method. In particular, for introducing or removing liquids from the liquid cooling system. By applying a vacuum to the liquid cooling loop, liquids may be removed or added to the liquid cooling loop.

The maintenance machine enables easily and safely carrying out maintenance on a liquid cooling system for a computer, in particular, on a plurality of individual liquid cooling systems for computers. This also enables efficiently maintaining the plurality of liquid cooling systems.

The maintenance machine has the same advantages as the method. Further, the maintenance machine may be supplemented with the features of the method described in this document, in particular, the features of the dependent claims of the method.

In a further aspect, a bypass valve block for connecting a maintenance machine to a liquid cooling system is provided. The bypass valve block comprises two main ports for connecting to a main flow path, in particular a liquid cooling loop, of the liquid cooling system, and a main fluid channel connecting the two main ports. The bypass valve block further comprises two auxiliary ports for connecting to the maintenance machine. Each auxiliary port is in fluid connection with the main fluid channel. Preferably, the auxiliary ports are connected to the main fluid channel at a distance from each other along the main channel. Further, the bypass valve block comprises at least a first valve, wherein the first valve is configured to selectively provide a fluid connection of the two main ports with each other, or a fluid connection of one of the main ports with one of the auxiliary ports. In the latter case no direct fluid connection is provided with the two main ports via the main flow channel.

In particular, a cooling liquid may flow through the main fluid channel and the main ports, when the bypass valve block is connected to or forms part of the liquid cooling loop of the liquid cooling system. Fluid lines of the maintenance machine may be reversibly connected to the auxiliary ports. When the maintenance machine is not connected to the auxiliary ports, the auxiliary ports may be sealed with suitable plugs, to avoid cooling liquid to flow out of the auxiliary ports. Similarly, the first valve may be actuated such that flow is selectively directed between the main ports and not to the one of the auxiliary ports. The bypass valve block enables easily and safely connecting the maintenance machine to the liquid cooling system.

Preferably, the bypass valve block comprises a second valve. The second valve is configured to selectively provide a fluid connection of the two main ports with each other, or a fluid connection of the other one of the main ports with the other one of the auxiliary ports. In the latter case no direct fluid connection is provided with the two main ports via the main flow channel. In particular, the second valve selectively provides fluid connection between ports that the first valve does not provide connections with. This enables accurate control of fluid flows through the valve block.

Preferably, at least one of the first valve and the second valve is one of a ball valve, a piston valve, or a spring-loaded valve actuated by a connector connected to the respective auxiliary port of the valve. This enables accurate control of fluid flows through the valve block. In particular, the first valve and the second valve may be of different types. In particular, the provision of a ball valve enables a low pressure drop across the valve.

Preferably, at least one of the ports comprises a threaded fitting, a push (-in/-on) or compression fitting, a barbed fitting, or a quick release fitting. This enables easy and safe connection of lines to the bypass valve. In particular, this enables easy and fast connection of the maintenance machine to the liquid cooling system comprising the bypass valve. A respective connector to be connected to the ports may comprise a spring-loaded valve. This enables reducing spills when connecting the connectors to the ports. Preferably, the ports and/or fittings are configured to enable tool-less connections.

Preferably, the main flow path through the main ports and the main fluid channel is substantially aligned with a longitudinal axis of the main fluid channel. This enables low pressure drop across the bypass valve block for fluid flow along the main fluid channel.

In a further aspect, a liquid cooling system for a computer is provided comprising at least one bypass valve block, in particular as described above. This enables easily and safely connecting the maintenance machine to the liquid cooling system via the bypass valve block. In particular, supply and return lines of the maintenance machine may be connected to the respective auxiliary ports of the bypass valve block. Moreover, the bypass valve block enables easy maintenance of the liquid cooling system without entire or partial disassembly of the liquid cooling system.

The liquid cooling system may comprise several bypass valve blocks. For example, the bypass valve blocks may be arranged along the liquid cooling loop such that they make it efficient to drain or fill the liquid cooling loop. For example, a bypass valve block for draining the liquid cooling system may be arranged at the lowest point of the liquid cooling loop.

In particular, the computer may comprise heat-generating electronic circuits, such as a CPU and a GPU, that may be cooling by means of the liquid cooling system. Generally, the computer may be a personal computer or a server, for example.

For example, the liquid cooling system may comprise at least one of the following components: a heat sink or heat exchanger configured to interface with a heat generating component, in particular of the computer, and to transfer heat from the heat generating component to the cooling liquid; a main cooling liquid flow path comprising fluid lines; a fluid pump configured to pump or circulate the cooling liquid through the liquid cooling system; a radiator configured to transfer heat from the cooling liquid to the environment, for example to surrounding air by convection or by forced ventilation by means of a fan; a fluid reservoir. The components of the liquid cooling system may be serially connected to form a liquid cooling loop, for example by means of the fluid lines. In particular, the cooling liquid may circulate through the liquid cooling loop. In the heat sink the cooling liquid heats up due to a transfer of heat from the heat generating component, in the radiator, the heat of the cooling liquid may be transferred to ambient air and the cooling liquid cools. The bypass valve block may be arranged along the liquid cooling loop, in particular, such that the main ports are fluidly connected to fluid lines of the liquid cooling system.

In a further aspect, an arrangement of the liquid cooling system and the maintenance machine is provided. The arrangement enables easy and safe maintenance of the liquid cooling system. In particular, the liquid cooling system may comprise the bypass valve block and the maintenance machine may be connected to the liquid cooling system via the bypass valve block. In particular, supply and return lines of the maintenance machine may be connected to the respective auxiliary ports of the bypass valve block.

The arrangement has the same advantages as the method and the maintenance machine. Further, the arrangement may be supplemented with the features of the method and the maintenance machine described in this document, in particular, the features of the dependent claims.

### Short description of the Figures

Hereinafter, a specific embodiment is described referring to the drawings, wherein:
- Figure 1: is a schematic view of an arrangement of a maintenance machine for carrying out maintenance on a liquid cooling system for a computer and a liquid cooling system for the computer,
- Figure 2: is a flow chart of a method for carrying out maintenance on a liquid cooling system for a computer,
- Figure 3: is a perspective view of a bypass valve block according to a first embodiment,
- Figure 4: is a side view of a bypass valve block according to a second embodiment,
- Figure 5: is a perspective view of a bypass valve block according to a third embodiment,
- Figure 6: is a perspective cut view of the bypass valve block according to Fig. 5, and
- Figure 7: is a perspective view of a bypass valve block according to a fourth embodiment.

### Detailed description

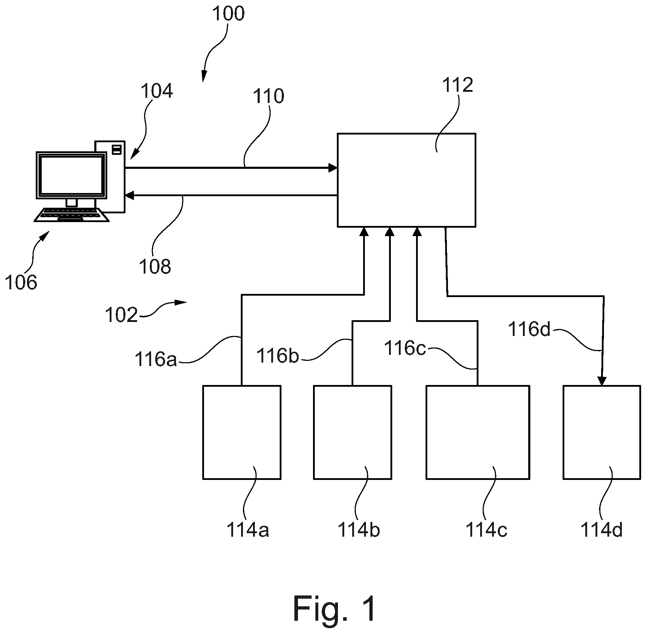

Figure 1 is a schematic view of an arrangement 100 of a maintenance machine 102 for carrying out maintenance on a liquid cooling system 104 and the liquid cooling system 104 for a computer 106. The liquid cooling system 104 is installed in the computer 106. In particular, heat sinks of the liquid cooling system 104 may be arranged on heat generating components of the computer 106 in order to remove heat by means of a circulating cooling liquid and a radiator. The components of the liquid cooling system 104 may be arranged as a liquid cooling loop, wherein the cooling liquid is circulated through the loop and the components in order to transfer heat from the heat generating components to the radiator.

The maintenance machine 102 is external to the liquid cooling system 104 and the computer 106. The maintenance machine 102 comprises a supply fluid line 108 and a return fluid line 110 by which the maintenance machine 102 is fluidly connected to the liquid cooling system 104. The maintenance machine 102 further comprises a main housing 112, which houses at least a pump and a manifold comprising valves to selectively bring into fluid connection a plurality of liquid containers 114a, 114b, 114c, 114d with the supply and/or return lines 108, 110. In particular, the liquid containers 114a, 114b, 114c may contain one of a cooling liquid, a cleaning liquid, or a rinsing liquid. The liquid container 114d may serve as a waste container, which waste liquids may be directed. Each of the containers is in fluid connection with the manifold by means of a respective container fluid line 116a, 116b, 116c, 116d. The valves of the manifold may be operated to selectively bring the liquid containers 114a, 114b, 114c, 114d into fluid connection with the liquid cooling system 104, in particular via the supply line and/or return line 108, 110. The maintenance machine 102 may comprise a pump to transport fluids through the lines 108, 110, 116a, 116b, 116c, 116d. The pump may be a positive-displacement pump that comes into contact with the fluid to be pumped.

Alternatively or in addition, fluids, in particular liquids, may be transported through the lines 108, 110, 116a, 116b, 116c, 116d by a pressurised gas. For example, the pump may be a compressor that generates a pressurised gas. The pressurised gas may force the liquid through the lines 108, 110, 116a, 116b, 116c, 116d and into the liquid cooling loop. For example, a headspace of the liquid containers 114a, 114b, 114c, 114d may be selectively pressurised and the respective liquid may flow out into the respective line 116a, 116b, 116c, 116d via a dip tube in the container 114a, 114b, 114c, 114d.

The pressurised gas may similarly be used to drain or remove liquids from the liquid cooling system 104.

Alternatively or in addition, the maintenance machine 102 may comprise a vacuum pump for generating a vacuum. The vacuum may be used to force liquids through the lines 108, 110, 116a, 116b, 116c, 116d and into the liquid cooling loop. This may reduce the introducing of gases such as air into the liquids.

The maintenance machine 102 may further comprise input means and/or output means. The input means may comprise a button configured to receive a method selection from a user, for example. The output means may comprise a display or a printer, for example. The output means may provide details of a method being carried out or having been carried out by the maintenance machine 102 to the user. For example, the output means may generate a maintenance report based on the steps of a method that was carried out on the liquid cooling system 104. For example, the maintenance report may comprise a positive leak-test result and the type of cooling liquid filled into the liquid cooling system 104.

The maintenance machine 102 is connected to the liquid cooling system 104 by means of the supply and return lines 108, 110. The liquid cooling system 104 preferably comprises a bypass valve block to reversibly connect the supply and return lines 108, 110 of the maintenance machine 102 to the liquid cooling system 104. In particular, the bypass valve block enables the maintenance machine 102 to form part of the liquid cooling loop of the liquid cooling system 104.

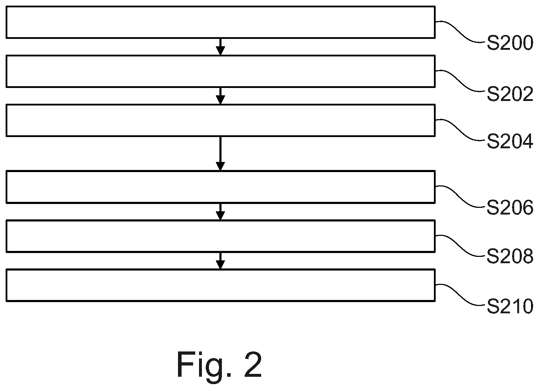

In particular, the maintenance machine 102 is configured to carry out the method that is further discussed below with Fig. 2.

Figure 2 is a flow chart of a method for carrying out maintenance on the liquid cooling system 104 for the computer 106. The method starts in step S200.

In step S202 the maintenance machine 102 is connected to the liquid cooling system 104. In particular, the supply and return lines 108, 110 may be connected to respective auxiliary ports of the bypass valve block of the liquid cooling system 104. The step S202 provide fluid connections between the maintenance machine 102 and the liquid cooling system 104.

Optionally, the step S202 may further comprise selecting a particular program or maintenance method to be performed by the maintenance machine 102 on the liquid cooling system 104.

As a further option, the step S202 may comprise draining the liquid cooling system 104, in particular in case any liquid is in the liquid cooling system 104 prior to the start of the method. For example, after the maintenance machine 102 is connected to the liquid cooling system 104, a pressurised gas may be introduced into the liquid cooling loop through the supply line 108. Any liquid remaining in the liquid cooling loop may be removed through the return line 110 into the waste container 114d by the pressurised gas.

In step S204 a leak test is carried out on the liquid cooling system 104 by means of the maintenance machine 102. The leak test may comprise initially pressurising the liquid cooling loop to a preset pressure, for example with a pressurised gas, and then waiting for a preset amount of time. If after the preset amount of time the pressure in the liquid cooling loop deviates from the preset pressure by a value greater than a preset margin, the leak test is failed. Otherwise, the leak test is passed. In case the leak test is failed, the leak test may be repeated, the user informed, or the method may be aborted.

In a next step S206, at least one of cleaning, rinsing and filling the liquid cooling system 104 is performed by means of the maintenance machine 102.

In a particularly preferred embodiment of the method, the liquid cooling system 104, in particular the liquid cooling loop is initially cleaned in steps S206. This may include flushing the liquid cooling loop with a cleaning liquid and subsequently removing the cleaning liquid to the waste container 114d. After this, the liquid cooling loop may be flushed with a rinsing liquid in order to remove any remaining cleaning liquid from the liquid cooling loop. After this, the cooling liquid may be filled into the liquid cooling loop.

In a subsequent step S208, a maintenance report is generated. The maintenance report may comprise the steps of the method that were performed, for example. The maintenance report may serve as verification that the steps of the method and the maintenance has been carried out correctly, in particular. Optionally, the step S208 may further comprise disconnecting the maintenance machine 102 from the liquid cooling system 104.

The method ends in step S210.

The method may alternatively only comprise the step S202, in which the maintenance machine 102 is connected to the liquid cooling system 104, and the step S206, in which the liquid cooling system 104 is filled with cooling liquid by means of the maintenance machine 102.

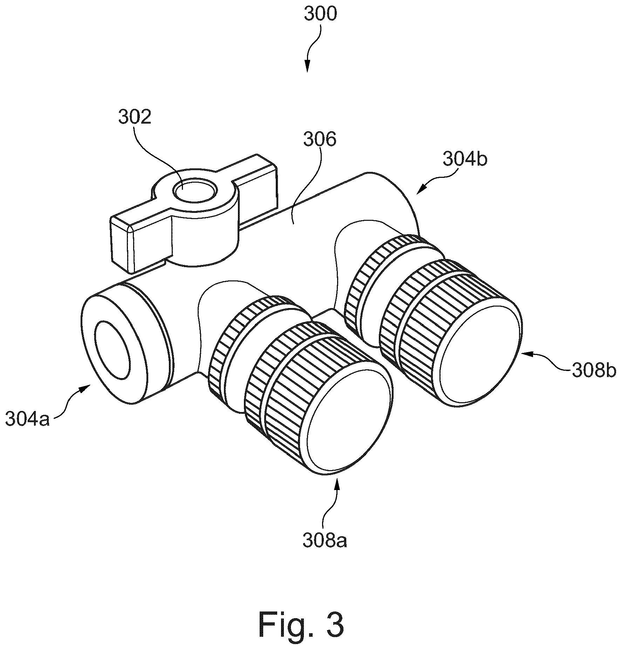

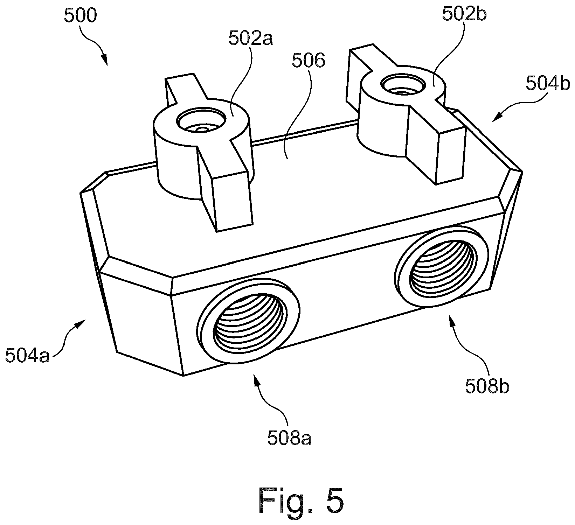

Figures 3 to 7 show several examples of bypass valve blocks, which may be used in the liquid cooling system 104, in particular to connect the maintenance machine 102 to.

Figures 3 to 7 show bypass valve blocks 300, 400, 500, 700 comprising a main fluid channel 306, 406, 506, 706. The bypass valve blocks 300, 400, 500, 700 further comprise first main ports 304a, 404a, 504a, 704a and second main ports 304b, 404b, 504b, 704b. The main ports 304a, 404a, 504a, 704a, 304b, 404b, 504b, 704b are configured to connect to fluid lines of the liquid cooling system 104. Together with the main fluid channel 306, 406, 506, 706 the main ports 304a, 404a, 504a, 704a, 304b, 404b, 504b, 704b may form part of the liquid cooling loop of the liquid cooling system 104. Thus, cooling liquid may flow through the main fluid channel 306, 406, 506, 706 of the bypass valve block 300, 400, 500, 700 when the liquid cooling system 104 is in use.

The bypass valve blocks 300, 400, 500, 700 further comprises a first auxiliary port 308a, 408a, 508a, 708a and a second auxiliary port 308b, 408b, 508b, 708b. The auxiliary ports 308a, 408a, 508a, 708a, 308b, 408b, 508b, 708b may be connected to the maintenance machine 102, in particular its supply and return lines 108, 110. The auxiliary ports 308a, 408a, 508a, 708a, 308b, 408b, 508b, 708b may be sealed, for example by means of a plug, when the maintenance machine 102 is not connected to the liquid cooling system 104.

The bypass valve blocks 300, 400, 500, 700 comprise at least a first valve 302, 402, 502a, 702a. The first valve 302, 402, 502a, 702a enables selectively diverting fluid flow from the main channel 306, 406, 506, 706 towards one of the auxiliary ports 308a, 408a, 508a, 708a, 308b, 408b, 508b, 708b. In particular, the first valve 302, 402, 502a, 702a may either fluidly connect the two main ports 304a, 404a, 504a, 704a, 304b, 404b, 504b, 704b, or one of the main ports 304a, 404a, 504a, 704a with one of the auxiliary ports 308a, 408a, 508a, 708a.

Thus, in case the maintenance machine 102 is connected to the auxiliary ports 308a, 408a, 508a, 708a, 308b, 408b, 508b, 708b, the first valve 302, 402, 502a, 702a enables diverting fluid flow from the liquid cooling loop of the liquid cooling system 104 towards the maintenance machine 102.

The bypass valve blocks 500, 700 further comprise a second valve 502b, 702b. In particular, the second valve 502b, 702b may either fluidly connect the two main ports 504a, 704a, 504b, 704b, or one of the main ports 504b, 704b with one of the auxiliary ports 508b, 708b.

The valves 302, 402, 502a, 502b, 702a, 702b of the bypass valve blocks 300, 400, 500, 700 may be actuated to either enable fluidly connecting the maintenance machine 102 to the liquid cooling system 104 when the flow is diverted to the auxiliary ports 308a, 408a, 508a, 708a, 308b, 408b, 508b, 708b, or to enable fluidly connecting the main ports 304a, 404a, 504a, 704a, 304b, 404b, 504b, 704b directly, in particular, when the maintenance machine 102 is not connected.

The bypass valve block 300, 500 comprises ball valves 302, 502a, 502b. The ball valves enable a streamlined design that reduces pressure drop across the valve 302, 502a, 502b.

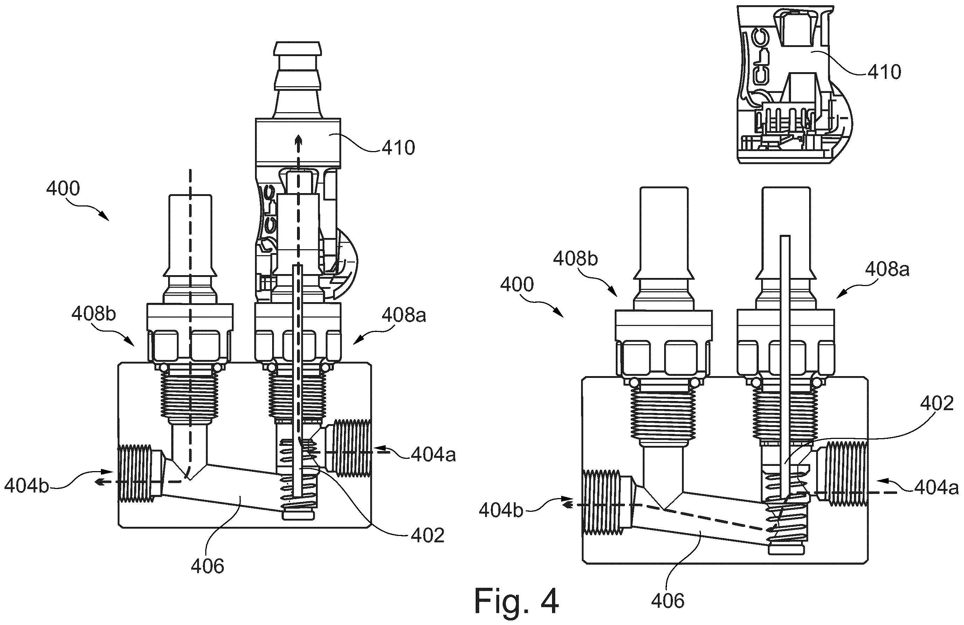

The bypass valve block 400 comprises a spring loaded valve 402, which is actuated by a connector 410 when it is connected to the auxiliary port 408a. As a specific example, the auxiliary ports 408a, 408b are quick release fittings that enable quick and tool-less release of the connector 410. The left display of Fig. 4 shows the connector 410 connected to the auxiliary port 408a and the spring loaded valve 402 actuated to divert flow towards the auxiliary port 408a. The right display of Fig. 4 shows the connector 410 disconnected from the bypass valve block 400 and the spring loaded valve 402 in a position where the two main ports 404a, 404b are in direct fluid connection.

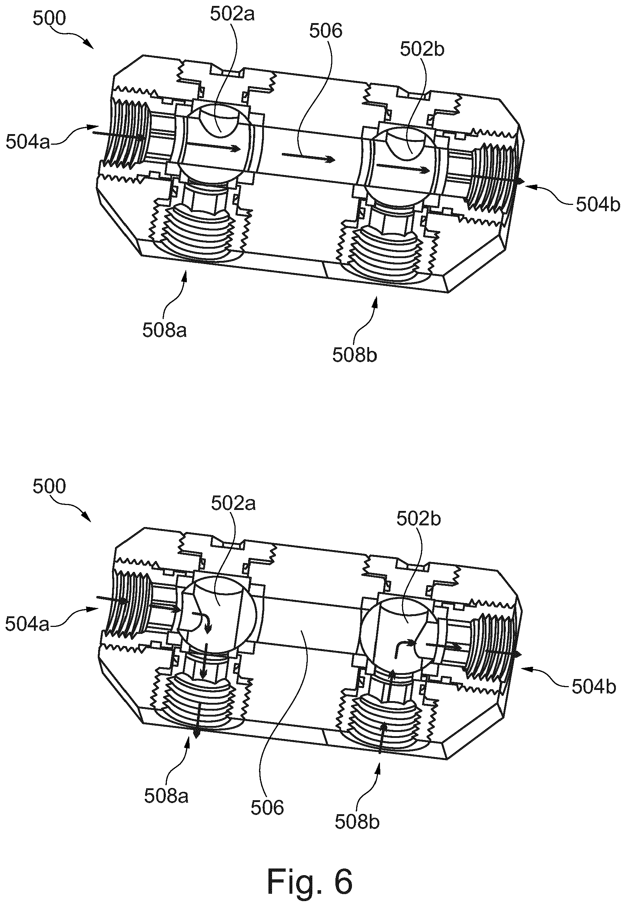

The top display of Fig. 6 shows the bypass valve block 500 with the valves 502a, 502b in a position where the two main ports 504a, 504b are in direct fluid connection. The bottom display of Fig. 6 shows the valves 502a, 502b in a position where the flow is selectively diverted towards the auxiliary ports 508a, 508b.

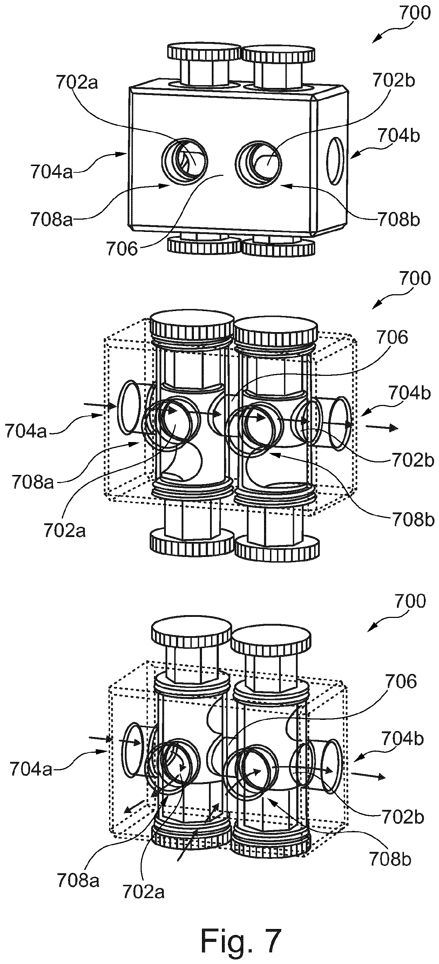

The valves 702a, 702b of the bypass valve block 700 are piston valves, which are actuated by moving a piston between two positions. In particular, the middle display of Fig. 7 shows the valves 702a, 702b in a position where the two main ports 704a, 704b are in direct fluid connection. The bottom display of Fig. 7 shows the valves 702a, 702b in a position where the flow is selectively diverted towards the auxiliary ports 708a, 708b.

### List of reference signs

- 100: Arrangement of maintenance machine and liquid cooling system
- 102: Maintenance machine
- 104: Liquid cooling system
- 106: Computer
- 108: Supply line
- 110: Return line
- 112: Main housing
- 114a, 114b, 114c: Liquid containers
- 114d: Waste container
- 116a, 116b, 116c, 116d: Container fluid line
- 300, 400, 500, 700: Bypass valve block
- 302: First valve, ball valve
- 304a, 404a, 504a, 704a: First main port
- 304b, 404b, 504b, 704b: Second main port
- 306, 406, 506, 706: Main fluid channel
- 308a, 408a, 508a, 708a: First auxiliary port
- 308b, 408b, 508b, 708b: Second auxiliary port
- 402: First valve, spring loaded valve
- 410: Connector
- 502a: First valve, ball valve
- 502b: Second valve, ball valve
- 702a: First valve, piston valve
- 702b: Second valve, piston valve

## Claims

1. A method for carrying out maintenance on a liquid cooling system (104) for a computer (106) comprising the following steps:
a) connecting a maintenance machine (102) to the liquid cooling system (104), and
b) filling the liquid cooling system (104) with a cooling liquid by means of the maintenance machine (102).

2. The method according to claim 1, wherein the maintenance machine (102) is connected to a bypass valve block (300, 400, 500, 700) of the liquid cooling system (104).

3. The method according to one of the preceding claims, wherein prior to step b), the liquid cooling system (104) is drained.

4. The method according to one of the preceding claims, wherein a leak test of the liquid cooling system (104) is performed.

5. The method according to one of the preceding claims, wherein a maintenance report is generated.

6. The method according to one of the preceding claims, wherein the liquid cooling system (104) is flushed with a cleaning liquid.

7. The method according to one of the preceding claims, wherein the liquid cooling system (104) is flushed with a rinsing liquid.

8. A maintenance machine (102) for carrying out maintenance on a liquid cooling system (104) for a computer (106), wherein the maintenance machine (102) comprises means to carry out the method according to one of the preceding claims.

9. A bypass valve block (300, 400, 500, 700) for connecting a maintenance machine (102) to a liquid cooling system (104), the bypass valve block comprising:
two main ports (304a, 404a, 504a, 704a, 304b, 404b, 504b, 704b),
a main fluid channel (306, 406, 506, 706) connecting the two main ports (304a, 404a, 504a, 704a, 304b, 404b, 504b, 704b),
two auxiliary ports (308a, 408a, 508a, 708a, 308b, 408b, 508b, 708b), wherein each auxiliary port (308a, 408a, 508a, 708a, 308b, 408b, 508b, 708b) is in fluid connection with the main fluid channel (306, 406, 506, 706), and
at least a first valve (302, 402, 502a, 702a), wherein the first valve (302, 402, 502a, 702a) is configured to selectively provide a fluid connection of the two main ports (304a, 404a, 504a, 704a, 304b, 404b, 504b, 704b) with each other, or a fluid connection of one of the main ports (304a, 404a, 504a, 704a, 304b, 404b, 504b, 704b) with one of the auxiliary ports (308a, 408a, 508a, 708a, 308b, 408b, 508b, 708b).

10. The bypass valve block according to claim 9, comprising a second valve (502b, 702b), wherein the second valve (502b, 702b) is configured to selectively provide a fluid connection of the two main ports (304a, 404a, 504a, 704a, 304b, 404b, 504b, 704b) with each other, or a fluid connection of the other one of the main ports (304a, 404a, 504a, 704a, 304b, 404b, 504b, 704b) with the other one of the auxiliary ports (308a, 408a, 508a, 708a, 308b, 408b, 508b, 708b).

11. The bypass valve block according to one of the preceding claims 9 and 10, wherein at least one of the first valve and the second valve is one of a ball valve, a piston valve, or a spring-loaded valve actuated by a connector connected to the respective auxiliary port.

12. The bypass valve block according to one of the preceding claims 9 to 11, wherein at least one of the ports (304a, 404a, 504a, 704a, 304b, 404b, 504b, 704b, 308a, 408a, 508a, 708a, 308b, 408b, 508b, 708b) comprises a threaded fitting, a push fitting, a barbed fitting, or a quick release fitting.

13. The bypass valve block according to one of the preceding claims 9 to 12, wherein a main flow path through the main ports (304a, 404a, 504a, 704a, 304b, 404b, 504b, 704b) and the main fluid channel (306, 406, 506, 706) is substantially aligned with a longitudinal axis of the main fluid channel.

14. A liquid cooling system (104) for a computer (106) comprising at least one bypass valve block (300, 400, 500, 700) according to one of the preceding claims 9 to 13.

15. An arrangement (100) of the liquid cooling system (104) according to claim 14 and the maintenance machine (102) according to claim 8.
